# EUROPÄISCHE PATENTANMELDUNG

(11) **EP 4 467 491 A1**
(43) Veröffentlichungstag der Anmeldung: **27.11.2024**
(21) Anmeldenummer: 24174696.5
(22) Anmeldetag: 08.05.2024
(51) Int. Cl.: B65G 47/86, B08B 9/42, C23C 14/00

(54) **BESCHICHTUNGSANLAGE SOWIE VERFAHREN ZUM BESCHICHTEN VON BEHÄLTERN**

(30) Priorität: 23.05.2023 DE 102023113416
(71) Anmelder: KHS GmbH, 44143 Dortmund (DE)
(72) Erfinder: Schetle, Andreas, 44143 Dortmund (DE)
(74) Vertreter: Andrejewski - Honke Patent- und Rechtsanwälte Partnerschaft mbB

(57) **Zusammenfassung**

Die Erfindung betrifft eine Beschichtungsanlage zum Beschichten von Behältern (6), insbesondere von Getränkebehältern, mit einem Beschichtungsrad (1) und einer Vielzahl von in Umfangsrichtung hintereinander an dem Beschichtungsrad (1) angeordneten Beschichtungsmodulen (4), welche jeweils eine Behälteraufnahme und eine der Behälteraufnahme zugeordnete Beschichtungseinheit aufweisen, welche dazu eingerichtet sind, die Behälter (6) während einer Rotation des Beschichtungsrades (1) zu beschichten und wobei jeweils zumindest zwei hintereinander angeordnete Beschichtungsmodule (4) zu einer Beschichtungsgruppe (5) zusammengefasst sind. Die Beschichtungsmodule (4) sind innerhalb einer Beschichtungsgruppe (5) in einer ersten Teilung (t₁) und zwei unmittelbar aneinander angrenzende Beschichtungsmodule (4) unterschiedlicher Beschichtungsgruppen (5) in einer zweiten Teilung (t₂) zueinander angeordnet, wobei die zweite Teilung (t₂) größer ausgebildet ist als die erste Teilung (t₁). Erfindungsgemäß grenzt ein Einlaufrad (7) unmittelbar an das Beschichtungsrad (1) an, wobei das Einlaufrad (7) dazu eingerichtet ist, zumindest zwei Behälter (6) im Zuge einer Umlaufbewegung in der ersten Teilung (t1) zueinander zu gruppieren und an die Beschichtungsmodule (4) einer Beschichtungsgruppe (5) zu übergeben.

## Beschreibung

Die Erfindung betrifft eine Beschichtungsanlage zum Beschichten von Behältern, insbesondere von Getränkebehältern, mit einem Beschichtungsrad und einer Vielzahl von in Umfangsrichtung hintereinander an dem Beschichtungsrad angeordneten Beschichtungsmodulen, welche jeweils eine Behälteraufnahme und eine der Behälteraufnahme zugeordnete Beschichtungseinheit aufweisen, welche dazu eingerichtet sind, die Behälter während einer Rotation des Beschichtungsrades zu Beschichten und wobei jeweils zumindest zwei hintereinander angeordnete Beschichtungsmodule zu einer Beschichtungsgruppe zusammengefasst sind und die Beschichtungsmodule innerhalb einer Beschichtungsgruppe in einer ersten Teilung und zwei unmittelbar aneinander angrenzende Beschichtungsmodule unterschiedlicher Beschichtungsgruppen in einer zweiten Teilung zueinander angeordnet sind, wobei die zweite Teilung größer ausgebildet ist als die erste Teilung.

Derartige Behälterbeschichtungsanlagen sind grundsätzlich aus dem Stand der Technik bekannt und dienen dazu, Behälter mit einer Innenbeschichtung zu versehen. Die Erfindung bezieht sich insbesondere auf Behälter aus dem Bereich der Lebensmitteltechnik, insbesondere der Getränketechnik. Entsprechend handelt es sich bei den Behältern um Getränkebehälter, beispielsweise um Getränkeflaschen. Die Getränkebehälter bestehen insbesondere aus Kunststoff z.B. aus Polyethylenterephthalat (PET) und werden vor der Beschichtung üblicherweise im Rahmen einer Blasumformung aus Vorformlingen ausgeformt.

Da insbesondere Polyethylenterephthalat nur geringe Barriereeigenschaften gegen das Eindringen von Sauerstoff und/oder das Austreten von Kohlendioxid oder anderen Gasen aufweist, kann mithilfe einer entsprechenden Beschichtungsanlage eine zusätzliche Barriereschicht innenliegend auf die Behälterwandungen aufgebracht werden.

Eine solche Beschichtung erfolgt üblicherweise mithilfe sogenannter Plasmabeschichtungsverfahren, wobei aus einem Plasma heraus die entsprechenden Schichten abgeschieden werden und sich auf den Wandungen des Getränkebehälters absetzen. In diesem Zusammenhang ist auch von sogenannten PICVD-Verfahren ("Plasma Impuls Chemical Vapor Deposition") die Rede, wobei insbesondere Schichten aus Siliziumoxid abgeschieden werden. Entsprechende Verfahren sind zum Beispiel aus der WO 03/100125 A1 und aus der WO 03/100121 A2 bekannt.

Die Beschichtung der Behälter erfolgt im Beschichtungsrad. Hierzu weist das Beschichtungsrad eine Vielzahl von Beschichtungsmodulen mit jeweils einer Behälteraufnahme und einer der Behälteraufnahme zugeordneten Beschichtungseinheit auf. Während der Beschichtung werden die Behälter innerhalb der Behälteraufnahmen zunächst evakuiert und sodann nach Einbringen verschiedener Gase über die Beschichtungseinheit die entsprechende Barriereschicht aus dem Plasma abgeschieden.

In modernen Abfüllanlagen sind die Beschichtungsanlagen Teil einer sogenannten verblockten Anlage. Dies bedeutet, dass die einzelnen Behandlungsanlagen unmittelbar über sogenannte Transfersterne miteinander in Verbindung stehen, sodass entsprechend die Behälter unmittelbar von einer Anlagenkomponente an eine weitere Anlagenkomponente übergeben werden.

Die verblockte Anordnung der einzelnen Anlagenkomponenten hat sich grundsätzlich bewährt, um einen störungsfreien und getakteten Betrieb zu ermöglichen. Allerdings hat dies auch zur Folge, dass die Behälter den einzelnen Anlagenkomponenten in einem exakt definierten Intervall zugeführt bzw. entnommen werden müssen. Sowohl bei dem Beschichtungsrad als auch bei anderen rotierenden Anlagenkomponenten führt dies ausgehend von einer definierten Drehgeschwindigkeit zu entsprechenden Teilungen, über die die Behälter z. B. in dem Beschichtungsrad bewegt werden. Bei einer Beschichtungsanlage kommt ergänzend hinzu, dass einzelne Beschichtungsmodule und damit auch die Behälteraufnahmen an dem Beschichtungsrad zueinander gruppiert sind, sodass die Beschichtung der Behälter innerhalb einer Beschichtungsgruppe gleichzeitig erfolgt. Bislang sind die einzelnen Beschichtungsgruppen so zueinander angeordnet, dass sämtliche Beschichtungsmodule und damit auch sämtliche Behälteraufnahmen dieselbe Teilung zueinander aufweisen.

Je nach Ausgestaltung der Beschichtungsanlage kann es jedoch erforderlich sein, die Anzahl der Beschichtungsmodule zu reduzieren. Um dennoch eine gleichmäßige Teilung zwischen sämtlichen Beschichtungsmodulen gewährleisten zu können, muss der Durchmesser des Beschichtungsrades reduziert bzw. die einzelnen Beschichtungsmodule auf einem kleineren Außenumfang angeordnet werden. Da aber eine Vielzahl der für den Betrieb der Beschichtungsanlage erforderlichen Komponenten innerhalb des Beschichtungsrades angeordnet ist, ist eine kleinere Auslegung des Durchmessers des Beschichtungsrades nicht immer ohne weiteres möglich.

Aus der EP 3 433 395 B1 ist ferner eine Ausgestaltung bekannt, bei der die Behälter zunächst über einen Luft- oder Bandtransport zugeführt werden und nach einer Vereinzelung zu Gruppen zu je zwei Behältern gruppiert werden. Diese gruppierten Behälter werden dann entsprechend über einen Eingabestern dem Beschichtungsrad zugeführt. Eine solche Ausgestaltung ist jedoch bei einer verblockten Anlage nicht ohne weiteres möglich.

Entsprechend kann also lediglich über eine Änderung bzw. Umkonstruktion der Beschichtungsgruppen eine gleichmäßige Verteilung der Beschichtungsmodule zueinander gewährleistet werden. Dies ist jedoch sehr aufwendig und mit hohen Kosten verbunden.

Der Erfindung liegt die Aufgabe zugrunde, eine Beschichtungsanlage anzugeben, welche einen flexiblen Einsatz ermöglicht und sich zugleich kosteneffektiv realisieren lässt.

Gegenstand und Lösung dieser Aufgabe ist eine Beschichtungsanlage gemäß Patentanspruch 1.

Dementsprechend ist vorgesehen, dass ausgehend von einer Ausgestaltung einer Beschichtungsanlage, bei der die Abstände der Beschichtungsmodule innerhalb einer Beschichtungsgruppe kleiner sind als die Abstände zwischen aneinandergrenzenden Beschichtungsmodulen benachbarter Beschichtungsgruppe sind, ein Einlaufrad unmittelbar an das Beschichtungsrad angrenzt, wobei das Einlaufrad dazu eingerichtet ist, zumindest zwei Behälter im Zuge einer Umlaufbewegung in der ersten Teilung zueinander zu gruppieren und an die Beschichtungsmodule einer Beschichtungsgruppe zu übergeben. Entsprechend erfolgt in dem Einlaufrad die Gruppierung von zumindest zwei Behältern gemäß der zweiten Teilung. Die Anzahl der zu gruppierenden Behälter orientiert sich an der Anzahl der Beschichtungsmodule innerhalb einer Beschichtungsgruppe im Beschichtungsrad.

Gemäß einer bevorzugten Ausgestaltung der Erfindung sind die zweiten Teilungen zwischen den einzelnen Beschichtungsgruppen gleich groß. Allerdings kann es im Rahmen der Erfindung auch vorgesehen sein, dass sich die zweiten Teilungen zwischen jeweils zwei Beschichtungsgruppen voneinander unterscheiden.

Die Anzahl der Beschichtungsmodule innerhalb einer Beschichtungsgruppe ist grundsätzlich nicht limitiert. Eine besonders bevorzugte Ausgestaltung sieht vor, dass zwischen zwei und sechs Beschichtungsmodule, insbesondere vier Beschichtungsmodule, zu einer Beschichtungsgruppe zusammengefasst sind, sodass sich die Gesamtzahl der Beschichtungsmodule aus der Anzahl der Beschichtungsgruppen und der Anzahl der Beschichtungsmodule innerhalb einer Beschichtungsgruppen ergibt.

Je geringer die Anzahl der Beschichtungsgruppen desto größer wird die zweite Teilung, während die erste Teilung gleich behalten wird. Entsprechend werden die Behälter innerhalb der Beschichtungsgruppen stets in einer konstanten ersten Teilung zueinander angeordnet, sodass entsprechend auch die Übergabe der Behälter in das Beschichtungsrad in einer gruppierten Art und Weise zu erfolgen hat.

Um eine entsprechende Gruppierung zu ermöglichen, ist das Beschichtungsrad dazu eingerichtet, die zu gruppierenden Behälter vor dem Übergeben an das Beschichtungsrad zusammenzuführen, wobei die unterschiedlichen Behälter unterschiedlich stark beschleunigt oder gebremst werden müssen. In diesem Zusammenhang ist darauf hinzuweisen, dass mit einem Einlaufrad grundsätzlich keine besondere Bauform verbunden ist, solange die an dem ein Laufrad angeordneten Behälteraufnahmen zur Aufnahme der Behälter umlaufend bewegbar sind. Entsprechend kann es sich beispielsweise um einen Kettenantrieb oder einen Linearantrieb handeln, an dem die Behälteraufnahmen angeordnet oder entlang der die Behälteraufnahmen bewegbar sind. Besonders bevorzugt ist jedoch die Ausgestaltung als Einlaufstern. Gemäß einer solchen Ausgestaltung rotieren die Behälter an einem Träger, sodass entsprechend sowohl der Einlaufstern als auch das Beschichtungsrad im Wesentlichen eine Kreisbewegung erfährt.

Gemäß einer bevorzugten Ausgestaltung der Erfindung grenzt ein Auslaufrad unmittelbar an das Beschichtungsrad an, wobei das Auslaufrad dazu eingerichtet ist, im Zuge einer Umlaufbewegung zumindest zwei Behälter in der ersten Teilung gruppiert aus den Beschichtungsmodulen einer Beschichtungsgruppe zu entnehmen. Das Auslaufrad kann in analoger Art und Weise zum Einlaufrad ausgebildet sein, sodass entsprechend die Bauform grundsätzlich nicht beschränkt ist, wobei aber auch hier bevorzugt ein Auslaufstern vorgesehen ist. Dieser Auslaufstern entnimmt die Behälter aus den Beschichtungsmodulen, sodass entsprechend zumindest im Übergabebereich die Behälteraufnahmen des Auslaufrades in einem Abstand zueinander gemäß der ersten Teilung angeordnet sind. Grundsätzlich können alle Behälteraufnahmen entlang des gesamten Umfangs gemäß der ersten Teilung zueinander angeordnet sein.

Besonders bevorzugt ist jedoch eine Ausgestaltung, bei der eine Anzahl der Behälteraufnahmen gemäß der Anzahl der kopierten Behälter in einem Abstand gemäß der ersten Teilung zueinander angeordnet sind und wobei sodann im Zuge der Rotation des Auslaufsterns bzw. im Zuge des Fortbewegens der Behälteraufnahmen die Teilung verändert wird. Gemäß einer solchen Ausgestaltung werden also die Behälter aus dem Beschichtungsrad entnommen und sodann die Teilung der Behälter zueinander durch Verschieben der Behälteraufnahmen relativ zueinander in einer dritten Teilung zueinander angeordnet. Gleiches kann auch in dem Einlaufstern erfolgen. In diesem Fall erfolgt dann ausgehend von einer dritten Teilung das Verschieben der Behälteraufnahmen zueinander in einer gruppierten Art und Weise in die erste Teilung.

Gemäß einer besonders bevorzugten Ausgestaltung sind dem Einlaufrad und/oder dem Auslaufrad jeweils unmittelbar ein Transportstern vor- bzw. nachgeschaltet, wobei der Transportstern dazu eingerichtet ist, die Behälter in einer dritten Teilung zu übergeben bzw. zu übernehmen. Somit erfolgt eine Übergabe der Behälter von dem Transportstern an das nachgeschaltete Einlaufrad bzw. eine Übergabe von dem Auslaufrad an den nachgeschalteten Transportstern. Diese Transportsterne sind üblicherweise dazu ausgebildet, die Behälter zu wenden, so dass im Zuge der Wendung vor dem Einlaufrad die Behälter kopfüber mit einer nach unten ausgerichteten Behälteröffnung angeordnet werden. In einem dem Auslaufrad nachgeschalteten Transportstern erfolgt dann eine Wendung zurück zur Ausrichtung der Behälter mit einer nach oben ausgerichteten Behälteröffnung. Zum Wenden können die Transportsterne Wendegreifer aufweisen.

Diese Transportsterne weisen eine dritte Teilung auf, wobei die dritte Teilung üblicherweise größer ist als die erste Teilung. Entsprechend werden die Behälter von dem Transportstern in der dritten Teilung an das Einlaufrad übergeben, wobei dann im Zuge der Bewegung der Behälteraufnahmen bzw. durch Rotation des Einlaufsterns zumindest zwei Behälter durch Bewegung relativ zueinander gemäß der ersten Teilung gruppiert werden.

Sodann erfolgte die Übergabe an das Beschichtungsrad. Im Auslauf werden die gruppierten Behälter dann im Auslaufrad relativ gegeneinander verschoben und der Abstand gemäß der dritten Teilung vergrößert. Entsprechend wird die gesamte Anlage gemäß der dritten Teilung betrieben, wobei aber durch das Einlaufrad und das Auslaufrad die Teilung für das Beschichtungsrad angepasst wird.

Eine bevorzugte Ausgestaltung der Erfindung sieht vor, dass das Einlaufrad und/oder das Auslaufrad zur Änderung der Teilung entlang des Umfangs verstellbare Greifer aufweisen. Entsprechend sind die Behälteraufnahmen des Einlauf- und/oder Auslaufrades als Greifer ausgebildet, wobei es sich insbesondere um passive Greifer handelt. Unter passiven Greifern wird verstanden, dass diese Greifer nicht aktiv zum Öffnen und Schließen angesteuert werden. Vielmehr bewirkt ein Federelement das Schließen der Greifer und damit zugleich auch die auf die Behälter einwirkende Greifkraft. Bei einem aktiven Greifer werden die Greifarme aktiv zum Verschießen und Öffnen angesteuert.

Die Behälter werden üblicherweise mit einem Kopfabschnitt in die Greifer herein- bzw. herausgedrückt. Besonders bevorzugt handelt sich um sogenannte Neckringhalter. Diese sind dazu ausgebildet, die Behälter an einem Neckring bzw. unterhalb eines Neckringes zu greifen. Bei dem Neckring handelt es sich um einen vorstehenden Materialabschnitt, welcher unterhalb eines am Kopfabschnitt angeordneten Außengewindes der Behälter angeordnet ist. Das Außengewinde dient der Aufnahme einer Verschlusskappe, welche über das Außengewinde heraufgedreht werden kann.

Die Greifer sind nunmehr nicht - wie üblich - fest an einer definierten Umfangsposition des Einlaufrades oder des Auslaufrades angeordnet. Vielmehr kann die Winkelposition verändert werden. Das bedeutet, dass die Greifer üblicherweise in einem Umfangsabschnitt beschleunigt und in einem weiteren Abschnitt abgebremst werden, wobei trotzdem alle Greifer eine im Mittel identische Umlaufgeschwindigkeit aufweisen. Entscheidend ist hierbei, dass je nach Anzahl der zu gruppierenden Behälter die für eine Gruppierung vorgesehenen Greifer unterschiedlich verstellt werden. Sofern also beispielsweise zwei Beschichtungsmodule zu einer Beschichtungsgruppe zusammengefasst sind, werden im Einlaufrad und/oder im Auslaufrad die Greifer des Einlaufrades ebenfalls zu Gruppen zu je zwei Greifern zusammengefasst, wobei diese beiden Greifer entlang des Umfangs unterschiedlich verstellt werden. Üblicherweise sind jeweils vier Beschichtungsmodule zu einer Beschichtungsgruppierung zusammengefasst, sodass entsprechend im Einlaufrad und/oder im Auslaufrad ebenfalls je vier Greifer unterschiedlich verstellt werden, um eine Gruppierung entsprechende der ersten Teilung zu ermöglichen.

Wie bereits zuvor erläutert, können die Greifer an Stellschlitten angeordnet sein, welche entlang einer Linearführung bewegbar sind. In diesem Fall können die einzelnen Beschleunigungs- und Abbremsprofile über eine Steuereinrichtung in den Stellschlitten hinterlegt sein, sodass besonders flexibel auf die unterschiedlichen Teilungen im Beschichtungsrad reagiert werden kann.

Besonders bevorzugt ist in diesem Zusammenhang aber eine Ausgestaltung, bei der zur Änderung der Teilung eine Kurvensteuerung mit einer ersten Steuerkurve und zumindest einer zweiten Steuerkurve vorgesehen ist, wobei eine erste Gruppe der Greifer der ersten und eine zweite Gruppe der Greifer der zweiten Steuerkurve zugeordnet ist. Die Greifer sind demnach jeweils mit einer Kurvenrolle verbunden, welche an den jeweiligen Steuerkurven abrollen. Das Einlaufrad ist üblicherweise als Einlaufstern bzw. dass Auslaufrad als Auslaufstern ausgebildet und rotiert demnach mit einer konstanten Drehgeschwindigkeit. Über die Steuerkurven ist es möglich, die Greifer und damit auch die Behälter über einen Abschnitt des Umfangs zu beschleunigen bzw. zu bremsen, wobei aber im Mittel die Greifer eine Geschwindigkeit gemäß der Drehgeschwindigkeit des Einlaufsterns bzw. des Auslaufstern aufweisen.

Eine Ausgestaltung mit zwei verschiedenen Steuerkurven ist insbesondere dann vorgesehen, wenn jeweils zwei Behälter zu gruppieren sind. Entsprechend weist dann auch das Beschichtungsrad jeweils zwei Beschichtungsmodule innerhalb einer Beschichtungsgruppe auf. Die Erfindung ist hierbei allerdings nicht auf eine solche Ausgestaltung beschränkt, so kann beispielsweise das Beschichtungsrad auch Beschichtungsgruppen zu je drei, vier oder fünf Beschichtungsmodulen aufweisen, wobei dann selbstverständlich auch das Einlaufrad und/oder das Auslaufrad drei, vier oder fünf Steuerkurven aufweist und wobei dann jeweils entsprechend eine Gruppe von Greifern einer entsprechenden Steuerkurve zugeordnet ist. Ausgehend von einer Ausgestaltung mit vier Steuerkurven sind demnach eine erste Gruppe von Greifern der ersten Steuerkurve, eine zweite Gruppe von Greifern der zweiten Steuerkurve, eine dritte Gruppe von Greifern der dritten Steuerkurve und eine vierte Gruppe von Greifer der vierten Steuerkurve zugeordnet. Eine Ausgestaltung mit Steuerkurve ist insbesondere deshalb von Vorteil, da sie sehr einfach zu realisieren ist und zugleich ein hohes Maß an Genauigkeit aufweist. So können insbesondere Fehlpositionierungen zwischen den Greifer und den Behälteraufnahmen im Beschichtungsrad vermieden werden.

Gemäß einer bevorzugten Ausgestaltung der Erfindung liegt das Verhältnis der zweiten zu der ersten Teilung zwischen 1,5 und 5, besonders bevorzugt zwischen 2,5 und 4.

Gegenstand der Erfindung ist ferner eine Behälterbehandlungsanlage mit einer Blasanlage und einer der Blasanlage nachgeschalteten Beschichtungsanlage, insbesondere eine Beschichtungsanlage der zuvor beschriebenen Art, wobei zur Überführung der Behälter zwischen der Blasanlage und der Beschichtungsanlage eine Transportvorrichtung vorgesehen ist, wobei die Transportvorrichtung zwischen den verblockten Anlagen mit Vorteil ausschließlich durch sogenannte Transport- bzw. Transfersterne realisiert ist. Ein fluidgetriebener Transport, insbesondere durch Druckluft, eine schwerkraftgetriebener Transport, beispielsweise durch Rutschen, ein schiebender Transport durch ein Aufstauen, ein Bandtransport oder dergleichen findet dabei in der Regel keine Anwendung. Erfindungsgemäß ist vorgesehen, dass die Transportvorrichtung dazu eingerichtet ist, die Behälter zueinander beabstandet zu transportieren.

Eine solche Ausgestaltung wird auch als verblockte Anordnung bezeichnet, da die Behälter mit vordefinierten Abständen geführt werden, welche durch die Führungsmittel der Transportvorrichtung vorgegeben werden. Entsprechend ist es nicht möglich, Behälter zu puffern. Der Abstand kann dann beispielsweise der dritten Teilung entsprechen.

Es liegt auch im Rahmen der Erfindung, eine Abfüllanlage der Beschichtungsanlage nachzuschalten, wobei dann ebenfalls eine entsprechende zweite Transportvorrichtung zwischen der Beschichtungsanlage und der Abfüllanlage angeordnet ist und wobei die erste und die zweite Transportvorrichtung identisch ausgebildet sind.

Gegenstand der Erfindung ist ferner ein Verfahren zum Beschichten von Behältern in einer erfindungsgemäßen Beschichtungsanlage, wobei zumindest zwei Behälter in einer ersten Teilung gruppiert und in einer zweiten Teilung beabstandet zu unmittelbar daran angrenzenden Behältern in einem Beschichtungsrad bewegt werden und wobei die Behälter während der Bewegung in dem Beschichtungsrad beschichtet werden. Insbesondere handelt es sich hierbei um eine innenliegende Beschichtung, sodass entsprechend während des Beschichtungsprozesses ein Vakuum innerhalb des Behälters erzeugt wird und sodann in diesem Vakuum aus einem Plasma heraus eine Materialschicht auf die Innenwände abgeschieden wird.

Gemäß dem erfindungsgemäßen Verfahren werden jeweils zwei Behälter zeitgleich beschichtet. Eine solche Ausgestaltung orientiert sich an einer Beschichtungsanlage mit jeweils zwei Beschichtungsmodulen innerhalb einer Beschichtungsgruppe. Besonders bevorzugt können aber auch drei, vier oder fünf Behälter in einer ersten Teilung gruppiert und in einer zweiten Teilung beabstandet zu unmittelbar daran angrenzenden Behältern in einem Beschichtungsrad bewegt werden. Entsprechend erfolgt dann das zeitgleiche Beschichten von drei, vier oder fünf Behältern, welche üblicherweise innerhalb einer Beschichtungsgruppe angeordnet sind.

Eine Weiterbildung der Erfindung sieht ferner vor, dass die Behälter in der ersten Teilung gruppiert dem Beschichtungsrad zugeführt und/oder entnommen werden.

Ausgehend hiervon kann die Teilung der zu gruppieren Behälter vor der Zuführung in das Beschichtungsrad verkleinert und/oder nach der Entnahme aus den Beschichtungsrad vergrößert werden. Entsprechend werden die Behälter vor und/oder nach den Beschichtungsrad mit einer anderen, insbesondere einer größeren, Teilung geführt als im Beschichtungsrad innerhalb einer Beschichtungsgruppe. Im Hinblick auf die zu gruppierenden Behälter wird dann die Teilung vor der Zuführung in das Beschichtungsrad angepasst, wobei sich die Verkleinerung bzw. die Vergrößerung der Teilung ausschließlich auf die zu gruppierenden Behälter unmittelbar vor der Zuführung in das Beschichtungsrad bzw. nach der Entnahme aus dem Beschichtungsrad bezieht.

Im Folgenden wird die Erfindung anhand eines Ausführungsbeispiels näher erläutert. Es zeigen:
- Fig. 1: eine schematische Darstellung einer Beschichtungsanlage aus dem Stand der Technik
- Fig. 2: eine schematische Darstellung einer erfindungsgemäßen Beschichtungsanlage.

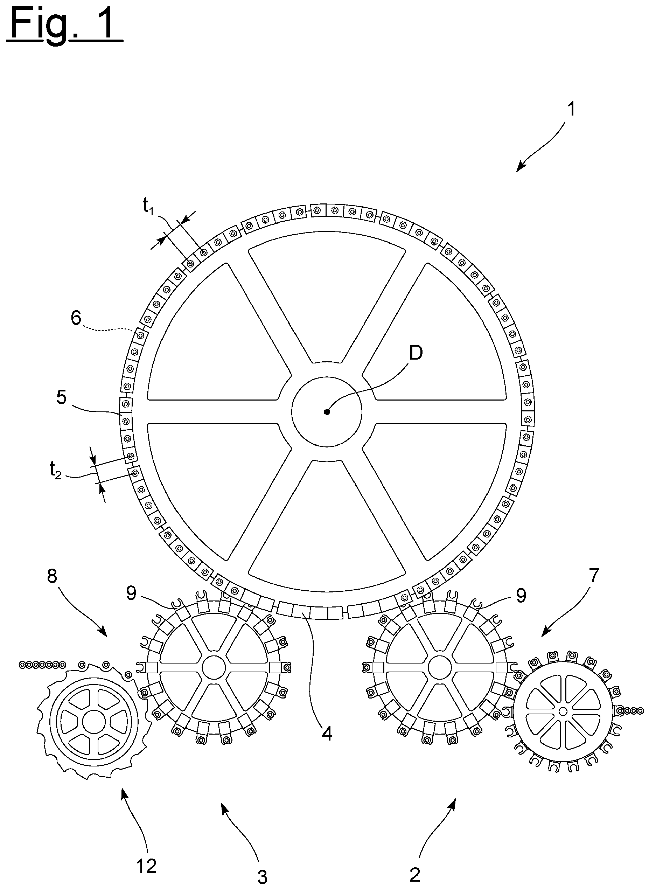

Die Fig. 1 zeigt eine aus dem Stand der Technik bekannte Beschichtungsanlage, welche als Behälterbeschichtungsanlage ausgebildet ist, wobei es sich bei den Behältern 6 in bevorzugter Weise um Getränkeflaschen aus Kunststoff, insbesondere aus Polyethylenterephthalat, handelt.

Die Beschichtungsanlage weist ein Beschichtungsrad 1 sowie eine vorgelagerte Einlaufanordnung 2 und eine nachgeschaltete Auslaufanordnung 3 auf. Das Beschichtungsrad 1 ist in einer Drehachse D rotierbar antreibbar und weist eine Vielzahl von in Umfangsrichtung angeordneten Beschichtungsmodulen 4 auf, welche jeweils eine Behälteraufnahme und eine der Behälteraufnahme zugeordnete Beschichtungseinheit aufweisen. Die Beschichtungseinheiten sind dazu eingerichtet, die Behälter 6 während einer Rotation des Beschichtungsrades 1 zu Beschichten, wobei im Rahmen der Erfindung üblicherweise zunächst ein Vakuum in den Behältern 6 erzeugt und sodann innenliegend in den Behältern 6 eine Beschichtung aus einem Plasma abgeschieden wird.

Die Beschichtungsmodule 4 sind ferner zu Beschichtungsgruppen 5 zu je vier Beschichtungsmodulen 4 zusammengefasst, sodass jeweils zeitgleich in den vier Beschichtungsmodulen 4 einer Beschichtungsgruppe 5 eine Beschichtung der Behälter 6 erfolgt. Die Beschichtungsmodule 4 sind hierbei so entlang des Umfangs an dem Beschichtungsrad 1 angeordnet, dass die Beschichtungsmodule 4 innerhalb einer Beschichtungsgruppe 5 in einer ersten Teilung t₁ und zwei unmittelbar aneinander angrenzenden Beschichtungsmodule 4 unterschiedlicher Beschichtungsgruppen 5 in einer zweiten Teilung t₂ zueinander angeordnet sind. Unter einer Teilung ist im Rahmen der Erfindung im Wesentlichen der Abstand der Beschichtungsmodule 4 zueinander zu verstehen, welcher sich auf den Umfang bezieht, an denen die Beschichtungsmodule 4 angeordnet sind. Die Besonderheit im Stand der Technik ist hierbei, dass die erste Teilung t₁ und die zweite Teilung t₂ identisch ausgebildet sind, sodass beide Teilungen t₁, t₂ sich aus dem Verhältnis von Umfang zur Anzahl der Beschichtungsmodule 4 ergeben. Eine solche Ausgestaltung hat den Vorteil, dass auch die Behälteraufnahmen in einer identischen Teilung t₁, t₂ und unabhängig von den Beschichtungsgruppen 5 zueinander angeordnet sind, sodass die Behälter 6 in einfacher Art und Weise über ein als Einlaufstern ausgebildetes Einlaufrad 7 eingebracht werden können. Dieses Einlaufrad 7 kann entsprechend einfach ausgebildet sein und eine Vielzahl von Greifern 9 aufweisen, wobei auch die Greifer 9 entsprechend der ersten bzw. der zweiten Teilung t₁, t₂ in Umfangsrichtung an dem Einlaufrad 7 angeordnet sind.

Das Gleiche gilt auch für die Auslaufanordnung 3, welche ebenfalls üblicherweise ein als Auslaufstern ausgebildetes Auslaufrad 8 aufweist, über welches die Behälter 6 aus den Beschichtungsrad 1 entnommen werden. Auch das Auslaufrad 8 kann Greifer 9 mit identischen Teilungen zueinander aufweisen, sodass sich insgesamt eine einfache Ausgestaltung ergibt.

Problematisch ist eine solche Ausgestaltung allerdings dann, wenn über die daran anschließenden Anlagenkomponenten eine andere Teilung vorgegeben wird bzw. wenn weniger Beschichtungsmodule 4 innerhalb eines Beschichtungsrades 1 gewünscht sind. In einem solchen Fall müsste dann der Umfang bzw. der Durchmesser des Beschichtungsrades 1 reduziert werden, um weiterhin eine konstante Teilung der Beschichtungsmodule 4 zueinander gewährleisten zu können. Da dies jedoch häufig nicht möglich ist, sieht die vorliegende Erfindung eine andere Ausgestaltungsform vor.

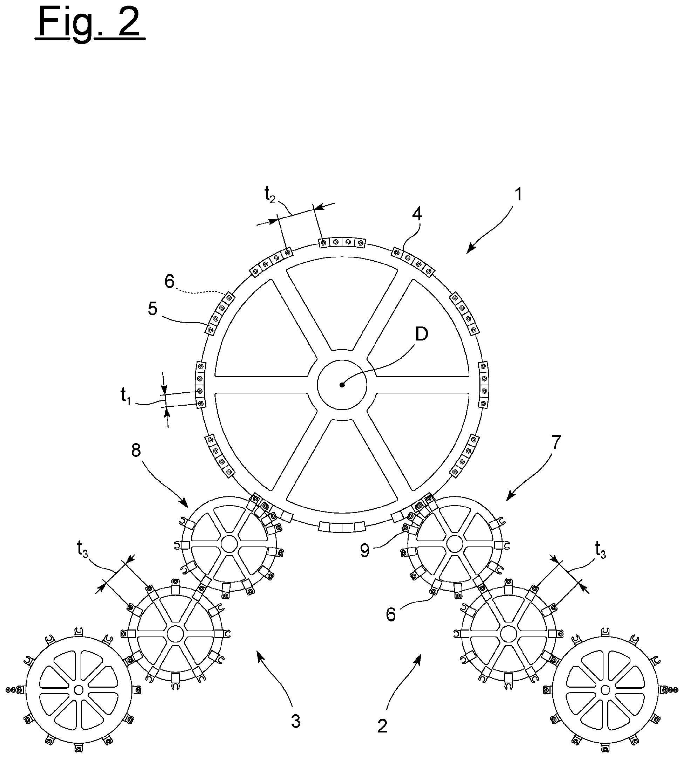

Die erfindungsgemäße Lösung ist in der Fig. 2 dargestellt.

Auch gemäß der Fig. 2 sind jeweils vier Beschichtungsmodule 4 an dem Beschichtungsrad 1 zu Beschichtungsgruppen 5 zusammengefasst, wobei die Teilung t₁ zwischen den Beschichtungsmodulen 4 einer Beschichtungseinheit 5 gegenüber dem Stand der Technik konstant gehalten wurde. Allerdings wurde bei gleichbleibendem Durchmesser bzw. Umfangs des Beschichtungsrades 1 die Anzahl der Beschichtungsgruppen 5 reduziert, sodass entsprechend die Teilung t₂, welche sich auf zwei Beschichtungsmodule 4 unterschiedlicher Beschichtungsgruppen 5 bezieht größer ist als die erste Teilung t₁.

Dies hat wiederum zur Folge, dass die Behälter 6 in einer gruppierten Art und Weise dem Beschichtungsrad 1 zugeführt bzw. wieder aus diesem entnommen werden müssen. Entsprechend sind sowohl das als Einlaufstern ausgebildete Einlaufrad 7 als auch das als Auslaufstern 8 ausgebildete Auslaufrad 8, welche jeweils unmittelbar an das Beschichtungsrad 1 angrenzen, dazu eingerichtet vier Behälter 6 im Zuge einer Umlaufbewegung in der ersten Teilung t₁ zueinander zu gruppieren und an die Beschichtungsmodule 4 einer Beschichtungsgruppe 5 zu übergeben bzw. im Falle des Auslaufrades 8 im Zuge einer Umlaufbewegung die vier Behälter in der ersten Teilung t₁ gruppiert aus den Beschichtungsmodulen 4 einer Beschichtungsgruppe 5 zu entnehmen.

Anhand der Fig. 1 ist hierbei ersichtlich, dass die Behälter 6 dem Einlaufstern 7 in einer dritten Teilung t₃ zugeführt werden und diese dann im Zuge einer Rotation des Einlaufrades 7 reduziert wird, sodass vor Übergabe an das Beschichtungsrad 1 die Behälter 6 in dem Einlaufrad 7 eine Teilung t₁ zueinander aufweisen. Eine solche Verstellung kann beispielsweise dadurch bewirkt werden, dass die Greifer 9 der zu gruppierenden Behälter 6 jeweils mit einer Kurvenrolle einer unterschiedlichen Steuerkurve zugeordnet sind, sodass die Greifer 9 während der Rotation an unterschiedlichen Stellen unterschiedlich stark beschleunigt oder abgebremst werden. Hierdurch kann dann über einen Umfangsabschnitt des Einlaufrades 7 der Abstand der Behälter 6 bzw. der Greifer 9 zueinander eingestellt werden, sodass sich bei Übergabe an das Beschichtungsrad 1 ein Abstand gemäß der Teilung t₁ einstellt.

Gleiches gilt dann auch für das Auslaufrad 8, welches die Behälter 6 in der zweiten Teilung t₂ übernimmt und durch Verstellen der Greifer 9 die Behälter 6 in eine dritte Teilung t₃ überführt.

## Patentansprüche

1. Beschichtungsanlage zum Beschichten von Behältern (6), insbesondere von Getränkebehältern, mit einem Beschichtungsrad (1) und einer Vielzahl von in Umfangsrichtung hintereinander an dem Beschichtungsrad (1) angeordneten Beschichtungsmodulen (4), welche jeweils eine Behälteraufnahme und eine der Behälteraufnahme zugeordnete Beschichtungseinheit aufweisen, welche dazu eingerichtet sind, die Behälter (6) während einer Rotation des Beschichtungsrades (1) zu beschichten und wobei jeweils zumindest zwei hintereinander angeordnete Beschichtungsmodule (4) zu einer Beschichtungsgruppe (5) zusammengefasst sind und wobei die Beschichtungsmodule (4) innerhalb einer Beschichtungsgruppe (5) in einer ersten Teilung (t₁) und zwei unmittelbar aneinander angrenzende Beschichtungsmodule (4) unterschiedlicher Beschichtungsgruppen (5) in einer zweiten Teilung (t₂) zueinander angeordnet sind, wobei die zweite Teilung (t₂) größer ausgebildet ist als die erste Teilung (t₁),
**dadurch gekennzeichnet, dass**
ein Einlaufrad (7) unmittelbar an das Beschichtungsrad (1) angrenzt und wobei das Einlaufrad (7) dazu eingerichtet ist, zumindest zwei Behälter (6) im Zuge einer Umlaufbewegung in der ersten Teilung (t₁) zueinander zu gruppieren und an die Beschichtungsmodule (4) einer Beschichtungsgruppe (5) zu übergeben.

2. Beschichtungsanlage nach Anspruch 1, **dadurch gekennzeichnet, dass** ein Auslaufrad (8) unmittelbar an das Beschichtungsrad (1) angrenzt und wobei das Auslaufrad (8) dazu eingerichtet ist, im Zuge einer Umlaufbewegung zumindest zwei Behälter (6) in der ersten Teilung (t₁) gruppiert aus den Beschichtungsmodulen (4) einer Beschichtungsgruppe (5) zu entnehmen.

3. Beschichtungsanlage nach Anspruch 1 oder 2, **dadurch gekennzeichnet, dass** dem Einlaufrad (7) und/oder dem Auslaufrad (8) jeweils unmittelbar ein Transportstern vor- bzw. nachgeschaltet sind, und wobei der Transportstern dazu eingerichtet ist, die Behälter (6) in einer dritten Teilung (t₃) zu übergeben bzw. zu übernehmen.

4. Beschichtungsanlage nach Anspruch 3, **dadurch gekennzeichnet, dass** der Transportstern dazu eingerichtet ist, die Behälter (6) zu wenden.

5. Beschichtungsanlage nach einem der vorhergehenden Ansprüche, **dadurch gekennzeichnet, dass** das Einlaufrad (7) und/oder das Auslaufrad (8) zur Änderung der zweiten Teilung (t₂) entlang des Umfangs verstellbare Greifer aufweisen.

6. Beschichtungsanlage nach Anspruch 5, **dadurch gekennzeichnet, dass** die Behälteraufnahmen als passive oder als aktive Greifer ausgebildet sind.

7. Beschichtungsanlage nach Anspruch 5 oder 6, **dadurch gekennzeichnet, dass** zur Änderung der zweiten Teilung (t₂) eine Kurvensteuerung mit einer ersten Steuerkurve und zumindest einer zweiten Steuerkurve vorgesehen ist, wobei eine erste Gruppe der Greifer (9) der ersten und eine zweite Gruppe der Greifer (9) der zweiten Steuerkurve zugeordnet ist.

8. Beschichtungsanlage nach Anspruch 5 oder 6, **dadurch gekennzeichnet, dass** die Behälteraufnahmen jeweils an einem entlang des Umfangs bewegbaren Stellschlitten angeordnet sind.

9. Beschichtungsanlage nach einem der vorangegangenen Ansprüche, **dadurch gekennzeichnet, dass** das Verhältnis der zweiten zu der ersten Teilung (t₁, t₂) zwischen 1,5 und 5 liegt.

10. Beschichtungsanlage nach einem der vorangegangenen Ansprüche, **dadurch gekennzeichnet, dass** zumindest vier hintereinander angeordnete Beschichtungsmodule (4) zu einer Beschichtungsgruppe (5) zusammengefasst sind.

11. Behälterbehandlungsanlage mit einer Blasanlage und einer der Blasanlage nachgeschalteten Beschichtungsanlage, insbesondere nach einem der vorangegangenen Ansprüche, wobei zur Überführung der Behälter (6) zwischen der Blasanlage und der Beschichtungsanlage eine Transportvorrichtung vorgesehen ist,
**dadurch gekennzeichnet, dass**
die Transportvorrichtung dazu eingerichtet ist, die Behälter (6) zueinander beabstandet zu transportieren.

12. Verfahren zum Beschichten von Behältern in einer Beschichtungsanlage nach einem der Ansprüche 1 bis 10, wobei zumindest zwei Behälter (6) in einer ersten Teilung (t₁) gruppiert und in einer zweiten Teilung (t₂) beabstandet zu unmittelbar daran angrenzenden Behältern in einem Beschichtungsrad (1) bewegt werden und wobei die Behälter während der Bewegung in dem Beschichtungsrad beschichtet werden.

13. Verfahren nach Anspruch 12, wobei die Behälter (6) in der ersten Teilung (t₁) gruppiert dem Beschichtungsrad (1) zugeführt und/oder entnommen werden.

14. Verfahren nach Anspruch 12 oder 13, wobei die Teilung (t₂) der zu gruppierenden Behälter (6) vor der Zuführung in das Beschichtungsrad (1) verkleinert und/oder nach der Entnahme aus dem Beschichtungsrad (1) vergrößert wird.
